# EUROPÄISCHE PATENTSCHRIFT

(11) **EP 1 488 465 B1**
(45) Veröffentlichungstag und Bekanntmachung des Hinweises auf die Patenterteilung: **29.04.2015**
(21) Anmeldenummer: 03711840.3
(22) Anmeldetag: 12.03.2003
(51) Int. Cl.: H01L 29/808, H01L 29/06

(54) **HALBLEITERAUFBAU MIT SCHALTELEMENT UND RANDELEMENT**
SEMI-CONDUCTOR STRUCTURE COMPRISING A SWITCH ELEMENT AND AN EDGE ELEMENT
STRUCTURE SEMICONDUCTRICE COMPORTANT UN ELEMENT DE COMMUTATION ET UN ELEMENT MARGINAL

(30) Priorität: 26.03.2002 DE 10213534
(43) Veröffentlichungstag der Anmeldung: 22.12.2004
(73) Patentinhaber: Infineon Technologies AG, 85579 Neubiberg (DE)
(72) Erfinder: DOHNKE, Karl-Otto, 96117 Memmelsdorf (DE); ELPELT, Rudolf, 91054 Erlangen (DE); FRIEDRICHS, Peter, 90475 Nürnberg (DE); MITLEHNER, Heinz, 91080 Uttenreuth (DE); SCHÖRNER, Reinhold, 91091 Grossenseebach (DE)
(74) Vertreter: Westphal, Mussgnug & Partner Patentanwälte mbB
(86) Internationale Anmeldenummer: PCT/DE2003/000790
(87) Internationale Veröffentlichungsnummer: WO 2003/081679

(56) Entgegenhaltungen:
- WO-A-00/16403
- WO-A-02/09195
- WO-A-96/03774
- WO-A-97/23911
- WO-A-98/49733
- WO-A-98/59377
- DE-A- 19 631 872

## Beschreibung

Die Erfindung betrifft einen zum Steuern und Schalten eines Stroms bestimmten Halbleiteraufbau, der mindestens ein Schaltelement mit einem mittels einer Anodenelektrode und einer Kathodenelektrode kontaktierten ersten Halbleitergebiet eines ersten Leitungstyps, innerhalb dessen ein Pfad für den Strom verläuft, mit einer zumindest teilweise innerhalb des ersten Halbleitergebiets angeordneten ersten Verarmungszone, die zur Stromsteuerung mittels einer an einer Steuerelektrode anstehenden Steuerspannung beeinflussbar ist, und mit einem mittels der Kathodenelektrode kontaktierten, zumindest teilweise innerhalb des ersten Halbleitergebiets vergrabenen Inselgebiet eines zweiten gegenüber dem ersten Leitungstyp entgegengesetzten Leitungstyps umfasst. Ein solcher Halbleiteraufbau ist aus der WO 00/16403 A1 bekannt.

Zum Versorgen eines elektrischen Verbrauchers mit einem elektrischen Nennstrom wird der Verbraucher üblicherweise über ein Schaltgerät an ein elektrisches Versorgungsnetz geschaltet. Beim Einschaltvorgang und auch im Falle eines Kurzschlusses kann ein Überstrom auftreten, der deutlich über dem Nennstrom liegt. Zum Schutz des elektrischen Verbrauchers muss das zwischen den Verbraucher und das elektrische Netz geschaltete Schaltgerät diesen Überstrom begrenzen und auch abschalten können. Weiterhin gibt es beispielsweise in der Umrichtertechnik Anwendungen, bei denen der Verbraucher im Falle einer in Sperrrichtung anliegenden Spannung auch sicher vom Versorgungsnetz getrennt werden soll. Für die beschriebenen Funktionen sind strombegrenzende Schalter in Form eines Halbleiteraufbaus bekannt.

So wird in der WO 00/16403 A1 und auch in der WO 02/09195 A1 jeweils ein Halbleiteraufbau beschrieben, bei dem ein zwischen einer Anoden- und Kathodenelektrode auf einem Strompfad durch den Halbleiteraufbau fließender Strom gesteuert wird. Insbesondere kann der Strom ein- und ausgeschaltet oder auf einen maximalen Wert begrenzt werden. Der aktive Teil des Halbleiteraufbaus besteht aus einem ersten Halbleitergebiet eines vorgegebenen Leitungstyps, insbesondere des n-Leitungstyps. Der Leitungstyp wird bestimmt durch den Typ der Ladungsträger, mit denen das Halbleitergebiet dotiert ist. Zur Stromsteuerung und -beeinflussung ist innerhalb des ersten Halbleitergebiets mindestens ein im Strompfad angeordnetes laterales Kanalgebiet vorgesehen. Unter lateral oder auch horizontal wird hierbei eine Richtung parallel zu einer Hauptoberfläche des ersten Halbleitergebiets verstanden. Vertikal wird dagegen eine senkrecht zur Hauptoberfläche verlaufende Richtung bezeichnet. Das laterale Kanalgebiet wird in vertikaler Richtung durch mindestens einen p-n-Übergang, insbesondere durch die Verarmungszone (Zone mit Verarmung an Ladungsträgern und damit hohem elektrischen Widerstand; Raumladungszone) dieses p-n-Übergangs, begrenzt. Die vertikale Ausdehnung dieser Verarmungszone kann unter anderem durch eine Steuerspannung eingestellt werden. Der p-n-Übergang ist zwischen dem ersten Halbleitergebiet und einem zweiten p-leitenden Gebiet gebildet. Ein zweiter das laterale Kanalgebiet in vertikaler Richtung begrenzender p-n-Übergang ist zwischen dem ersten Halbleitergebiet und einem vergrabenen Inselgebiet gebildet.

Der bekannte Halbleiteraufbau hat grundsätzlich eine hohe Sperrspannungsfestigkeit. Dies gilt insbesondere, wenn als Halbleitermaterial Siliciumcarbid (SiC) verwendet wird. Am Rand des Halbleiteraufbaus kann es jedoch zu einer die Sperrspannungsfestigkeit vermindernden Überhöhung des elektrischen Oberflächenfelds kommen.

Zur Reduzierung eines derartigen kritischen Oberflächenfelds wird in der EP 0 772 889 B1 ein sogenannter JTE(= Junction Termination Extension)-Randabschluss zum Einsatz in einem insbesondere in SiC realisierten Halbleiteraufbau beschrieben. Ein solcher JTE-Randabschluss beruht auf einem kontrollierten Hinzufügen von Ladungen des zweiten Ladungstyps in die Oberfläche des als Driftgebiet vorgesehenen ersten Halbleitergebiets. Insbesondere ist dabei eine niedrigere Dotierung als in den übrigen Gebieten des zweiten Leitungstyps vorgesehen. Durch den JTE-Randabschluss wird das elektrische Feld an der Oberfläche aufgeweitet und die Feldkrümmung verringert, so dass sich die Sperrspannungsfestigkeit des Halbleiteraufbaus erhöht. Im Detail wird in der EP 0 772 889 B1 die Ausgestaltung eines JTE-Randabschlusses für eine p-n-Diode und einen MOSFET beschrieben. Für andere Bauelementeformen des Halbleiteraufbaus werden allerdings keine konkrete Angaben über die Realisierung des JTE-Randabschlusses gemacht.

Konkrete Angaben fehlen insbesondere auch für die verschiedenen Ausführungsformen eines in einer sogenannten Kaskodenschaltung eingesetzten Hochvolt-Schaltelements. Die Kaskodenschaltung ist beispielsweise aus der US 6,157,049 A bekannt. Die dort offenbarte elektronische Schalteinrichtung basiert auf einer speziellen Zusammenschaltung eines Niedervolt- und des Hochvolt-Schaltelements. Die Schalteinrichtung dient zum Schalten eines hohen elektrischen Stroms und ist auch in der Lage, eine hohe Betriebsspannung sicher zu sperren. Das Niedervolt-Schaltelement, ein selbstsperrender (= normally off) MOSFET, besteht insbesondere aus Silicium (Si) und sorgt dafür, dass die Zusammenschaltung mit dem als selbstleitender (= normally on) JFET ausgebildeten Hochvolt-Schaltelement auch insgesamt eine selbstsperrende Einheit ergibt. Das Hochvolt-Schaltelement besteht aus einem Halbleitermaterial mit einer Durchbruchfeldstärke von mehr als 10⁶ V/cm, beispielsweise also auch aus SiC. Es nimmt dann im Sperrfall den wesentlichen Teil der an der Kaskodenschaltung anstehenden zu sperrenden Spannung auf.

Weiterhin ist aus der DE 196 31 872 A1 ein vertikales Halbleiterbauelement mit einem Halbleiterkörper bekannt, der mindestens einen aktiven Halbleiter-Materialkontakt aufweist, bei dem im Halbleitergebiet vergrabene Inselgebiete anderer Dotierung vorhanden sind. Eine Kontaktierung der Inselgebiete ist nicht vorhanden.

Weiterhin ist aus der WO 98/59377 A1 ein Halbleiter-Strombegrenzer mit Kaltleitschichten unterschiedlicher Dotierung, einem lateralen Kanalgebiet und einem lateralen Inselgebiet vorhanden, bei dem bei Überschreiten eines vorgegebenen Sättigungsstromes das laterale Kanalgebiet abgeschnürt und der Strom auf einen Wert unterhalb des Sättigungsstromes begrenzt wird. Schließlich ist aus der WO 96/03774 A1 ein Halbleiter-Bauelement mit hochsperrendem Randabschluss bekannt, bei dem die Verarmungszone eines aktiven Bereiches mit einer von einer angelegten Sperrspannung abhängigen vertikalen Ausdehnung aufgenommen wird.

Der Erfindung liegt nun die Aufgabe zu Grunde, einen Halbleiteraufbau der eingangs bezeichneten Art anzugeben, der eine hohe Sperrspannungsfestigkeit und damit eine bessere Effektivität als beim Stand der Technik aufweist.

Zur Lösung der Aufgabe wird ein Halbleiteraufbau entsprechend den Merkmalen des unabhängigen Patentanspruchs 1 angegeben.

Bei dem erfindungsgemäßen Halbleiteraufbau zur Steuerung eines Stroms handelt es sich um einen Halbleiteraufbau der eingangs bezeichneten Art, der außerdem ein Randelement mit einem zumindest teilweise innerhalb des ersten Halbleitergebiets vergrabenen Randgebiet des zweiten Leitungstyps, das auf gleicher Höhe wie das vergrabene Inselgebiet angeordnet ist, und ein an das Randgebiet angrenzendes Randabschlussgebiet des zweiten Leitungstyps umfasst und bei dem zwischen der Steuerelektrode und dem Randgebiet eine elektrisch leitende Verbindung besteht.

Die Erfindung beruht dabei auf der Erkenntnis, dass es vorteilhaft ist, wenn das Randgebiet in einer Ebene mit dem vergrabenen Inselgebiet des Schaltelements liegt. Durch eine solche Anordnung auf gleicher Höhe lassen sich im Sperrfall unerwünschte Feldüberhöhungen an der dem Randelement zugewandten Ecke desjenigen vergrabenen Inselgebiets, das Teil des an das Randelement angrenzenden Schaltelements ist, vermeiden. Das Inselgebiet dient im Schaltelement insbesondere der Abschirmung der Kathodenelektrode. Die Anordnung von Insel- und Randgebiet auf gleicher Höhe führt zu einer reduzierten Potentiallinienkrümmung, so dass der Halbleiteraufbau bei ansonsten gleicher Dotierung und Dicke eine um etwa 30 % erhöhte Sperrspannungsfestigkeit aufweist.

Diesbezüglich günstig wirkt sich auch die Tatsache aus, dass das Randabschlussgebiet des zweiten Leitungstyps an das Randgebiet angrenzt. Insbesondere befindet sich das Randabschlussgebiet auf der vom Schaltelement abgewandten Seite des Randgebiets. Vorzugsweise ist das Randabschlussgebiet niedriger dotiert als das Randgebiet. Es wird somit ein JTE-Randabschluss gebildet. Das Randgebiet und das Randabschlussgebiet liegen insbesondere in einer Ebene mit dem vergrabenen Inselgebiet des Schaltelements. Eine ebenso denkbare und auf den ersten Blick gegebenenfalls sogar einfacher erscheinende Variante, bei der das Randabschlussgebiet auf gleicher Höhe mit der durch die Steuerelektrode beeinflussbaren ersten Verarmungszone angeordnet ist, würde die genannte Feldüberhöhung am Inselgebiet des benachbarten Schaltelements gar nicht oder nur schlechter unterdrücken. Das an das Randgebiet angrenzende Randabschlussgebiet führt dagegen zu einer deutlichen Reduzierung der kritischen Potentiallinienkrümmung an der Ecke des vergrabenen Inselgebiets, so dass sich eine weiter verbesserte Sperrspannungsfestigkeit des Randelements einstellt.

Ein weiterer Vorteil besteht darin, dass die im Randelement und auch im Grenzbereich des angrenzenden Schaltelements im Sperrfall auftretenden Feldstärkewerte erheblich reduziert werden. Der Halbleiteraufbau hat dann also im Randelement eine in etwa vergleichbar hohe Sperrspannungsfestigkeit wie im Volumen der insbesondere in großer Anzahl vorhandenen Schaltelemente. Ein etwaiger Avalanche-Durchbruch tritt dann im Sperrfall zum einen erst bei einer höheren Sperrspannung und zum anderen nicht wie bei einem konventionellen Randelement, das eine schlechtere Sperrspannungsfestigkeit aufweist, bevorzugt im Bereich des Randelements auf. Vielmehr ist die Wahrscheinlichkeit eines Avalanche-Durchbruchs dann über die gesamte Fläche des Halbleiteraufbaus in etwa gleich verteilt. Dadurch wird der üblicherweise für gar keinen oder nur für einen sehr kleinen Stromfluss dimensionierte Steuerkreis entlastet. Der bei einem Avalanche-Durchbruch generierte hohe Strom fließt nämlich größtenteils im ohnehin für einen hohen Stromwert ausgelegten Lastkreis.

Auch die elektrisch leitende Verbindung zwischen der Steuerelektrode und dem Randgebiet bietet Vorteile. Diese Verbindung kann dabei insbesondere durch ein gesondertes innerhalb des ersten Halbleitergebiets angeordnetes Verbindungsgebiet oder auch dadurch hergestellt werden, dass die Steuerelektrode auch direkt das Randgebiet ohmsch kontaktiert. Im zuletzt genannten Fall erstreckt sich die Metallisierung der Steuerelektrode bis zu einem gegebenenfalls freigelegten Teil der Oberfläche des Randgebiets. Ein Schaltelement mit einem Randelement, bei dem das Randgebiet an die Steuerelektrode angeschlossen ist, lässt sich bevorzugt in einer Kaskodenschaltung einsetzen. Im Gegensatz zu dem bekannten Randabschluss für den MOSFET, bei dem ein dem Randgebiet vergleichbares Gebiet an die Sourceelektrode (entspricht der Kathodenelektrode) angeschlossen ist, ist ein Anschluss des Randgebiets an die Steuerelektrode günstiger. Die Verwendung in einer Kaskodenschaltung führt nämlich dazu, dass die Steuerelektrode des als Hochvolt-Schaltelement fungierenden Halbleiteraufbaus elektrisch mit einem der beiden Hauptanschlüsse der Kaskodenschaltung verbunden ist und damit im Sperrfall auch am vollen Sperrpotential liegt.

Vorteilhafte Ausgestaltungen des Halbleiteraufbaus gemäß der Erfindung ergeben sich aus den von Anspruch 1 abhängigen Ansprüchen.

Weiterhin gibt es eine Ausführungsform mit einem innerhalb des ersten Halbleitergebiets angeordneten insbesondere lateralen Kanalgebiet, durch das der Strompfad verläuft. Innerhalb dieses Kanalgebiets lässt sich der Stromfluss dann mittels wenigstens einer der beiden Verarmungszonen auf sehr einfache Weise beeinflussen. Dies geschieht beispielsweise über eine kontrollierte Veränderung der lokalen Ausdehnung der Verarmungszone. Dadurch erhält man die gewünschte Steuerung der Stromtragfähigkeit im Kanalgebiet und auch des Stromflusses zwischen Anoden- und Kathodenelektrode. Günstig ist es in diesem Zusammenhang außerdem, wenn sich die erste Verarmungszone und das vergrabene Inselgebiet des Schaltelements in einer senkrecht zu einer Oberfläche des ersten Halbleitergebiets vorgenommenen fiktiven Projektion in eine gemeinsame Ebene an ihren lateralen (= seitlichen) Rändern überlappen. Das laterale Kanalgebiet verläuft dann gerade im Bereich dieser Überlappung.

Bei einer weiteren Variante ist die erste Verarmungszone, die insbesondere das laterale Kanalgebiet in vertikaler Richtung begrenzt, die Verarmungszone eines p-n-Übergangs, der sich zwischen dem ersten Halbleitergebiet und einem zweiten Halbleitergebiet befindet. Das zweite Halbleitergebiet ist an einer Oberfläche innerhalb des ersten Halbleitergebiets angeordnet. Es hat den gegenüber dem Leitungstyp des ersten Halbleitergebiets entgegengesetzten Leitungstyp und ist mittels der Steuerelektrode ohmsch kontaktiert. Durch Anlegen einer Steuerspannung an diese Steuerelektrode kann die Ausdehnung der ersten Verarmungszone und damit der elektrische Widerstand des lateralen Kanalgebiets gesteuert werden. Grundsätzliche kann die in ihrer Ausdehnung variierbare erste Verarmungszone aber auch in anderer Form realisiert werden, beispielsweise mittels eines MIS (Metal Isolator Semiconductor)-Kontakts oder eines Schottky-Kontakts. Diese Ausführungsformen sind in der WO 00/16403 A1 und auch in der WO 02/09195 A1 beschrieben.

Bevorzugt ist die erste Verarmungszone oberhalb des vergrabenen Inselgebiets angeordnet, d.h. die erste Verarmungszone verläuft in einer Ebene oder besser gesagt in einer Schicht des Halbleiteraufbaus, die über derjenigen des vergrabenen Inselgebiets liegt. Im Grenzbereich zwischen dem Randelement und dem benachbarten Schaltelement befindet sich dann die erste Verarmungszone in diesem Sinne auch oberhalb des Randgebiets. Erste Verarmungszone sowie Inselgebiet und Randgebiet können seitlich gegeneinander versetzt angeordnet sein und insbesondere auch unterschiedliche laterale Abmessungen aufweisen.

Vorzugsweise sind mehrere, insbesondere gleichartige und zueinander parallel geschaltete Schaltelemente vorgesehen. Sie sind seitlich nebeneinander angeordnet, so dass sich ein Zellendesign ergibt. Auf diese Weise kann die Stromtragfähigkeit des Halbleiteraufbaus erhöht werden. Außerdem erreicht man so eine hohe Packungsdichte und damit eine gute Ausnutzung der Halbleiterfläche. Eine dann besonders günstige Kontaktierung ermöglicht ein besonders schnelles Umschalten der Schaltelemente.

Günstig im Hinblick auf die Sperrspannungsfestigkeit wirkt es sich aus, wenn die Abstände zwischen benachbarten Schaltelementen und insbesondere zwischen den vergrabenen Inselgebieten benachbarter Schaltelemente jeweils in etwa gleich groß sind. Ein typischer Abstandswert liegt bei etwa 5 µm. Ein anderes Abstandsmaß ist jedoch ebenfalls möglich. Durch das in etwa eingehaltene Abstandsmaß wird sichergestellt, dass die Potentiallinien möglichst gleichmäßig im Volumen des Halbleiteraufbaus verlaufen. Insbesondere wird eine Feldüberhöhung infolge eines stärker gekrümmten Potentiallinienverlaufs, der sich bei stark schwankenden Abständen zwischen den Inselgebieten an den Ecken oder seitlichen Kanten der Inselgebiete einstellen könnte, vermieden. Vorzugsweise sollte das einheitliche Abstandsmaß der Schaltelemente untereinander auch im Randbereich beachtet werden. Günstig ist es insbesondere, wenn der Abstand zwischen dem vergrabenen Inselgebiet des an das Randelement angrenzenden Schaltelements und dem Randgebiet des Randelements höchstens gleich groß wie das einheitliche Abstandsmaß zwischen den Schaltelementen ist. Vorzugsweise ist dieser Randabstand kleiner als das einheitliche Abstandsmaß zwischen den Schaltelementen. Damit wird auch an dieser Stelle eine unerwünschte Feldüberhöhung unterbunden. Das Rastermaß des Zelldesigns sollte also gerade im Hinblick auf ein gutes Sperrvermögen - am Rand aber auch im Volumen - möglichst genau eingehalten werden.

Bevorzugt enthält der Halbleiteraufbau ein Steuerkontaktelement, das eine großflächige Anschlussmöglichkeit für eine externe Steuerzuleitung an die untereinander verbundenen Steuerelektroden der Schaltelemente bietet. Das Steuerkontaktelement ist zwischen zwei Schaltelementen angeordnet. Um die Kontaktierung zu ermöglichen, ist es insbesondere größer als ein Schaltelement.

Auch das Steuerkontaktelement kann mindestens ein vergrabenes Inselgebiet des zweiten Leitungstyps beinhalten. Letzteres ist insbesondere auf der gleichen Höhe angeordnet wie die vergrabenen Inselgebiete der Schaltelemente. Die vergrabenen Inselgebiete des Steuerkontaktelements sind bevorzugt nicht mit denen der Schaltelemente elektrisch verbunden. Sie sind vielmehr floatend ausgebildet. Damit liegt auch im Bereich des Steuerkontaktelements eine ähnliche oder gar die gleiche Feldverteilung ohne unerwünschte Feldspitzen wie im übrigen Halbleiteraufbau vor. Dies wird weiter dadurch begünstigt, dass auch die vergrabenen Inselgebiete des Steuerkontaktelements untereinander und zu denen der angrenzenden Schaltelemente den einheitlichen durch das Rastermaß vorgegebenen Abstand aufweisen.

Weiterhin enthält das Steuerkontaktelement zum Anschluss der externen Steuerzuleitung ein insbesondere großflächiges und mit einer Metallisierung versehenes Steuer-Kontaktgebiet des zweiten Leitungstyps. Es kann oberhalb der vergrabenen Inselgebiete des Steuerkontaktelements angeordnet sein oder auch mit diesen zusammenfallen. Im letzteren Fall ergibt sich ein beispielsweise mittels Ätzung hergestellter abgesenkter Steuerelektroden-Anschluss. An dessen seitlichem Rand wird wieder der einheitliche Abstand zu den vergrabenen Inselgebieten der benachbarten Schaltelemente eingehalten.

Bei einer anderen Variante wird auch zur Kontaktierung des vergrabenen Randgebiets ein Materialabtrag des ersten Halbleitergebiets im Bereich des Randelements vorgesehen, so dass das Randgebiet zumindest teilweise freigelegt wird. In einer so gebildeten Ausnehmung erfolgt die Kontaktierung des Randgebiets mittels der Steuerelektrode. Ein seitlicher an das erste Halbleitergebiet angrenzender Rand der Ausnehmung ist mit einer insbesondere zwischen der Kontaktmetallisierung der Steuerelektrode und dem ersten Halbleitergebiet angeordneten Isolierung versehen. Dadurch kann ein Leckstrom zwischen der Kathoden- und der Steuerelektrode vermieden werden. Als Isolierung sind verschiedene Ausführungsformen denkbar. Es kann beispielsweise ein Verbindungsgebiet des zweiten Leitungstyps am seitlichen Rand der Ausnehmung innerhalb des ersten Halbleitergebiets verlaufen. Alternativ ist aber auch eine Oxidschicht oder eine spezielle Wahl des Kontaktmetalls, so dass sich auf dem den ersten Leitungstyp aufweisenden ersten Halbleitergebiet ein Schottky-Kontakt bildet, möglich.

In einer vorteilhaften Ausgestaltung besteht der Halbleiteraufbau teilweise oder auch komplett aus einem Halbleitermaterial, das einen Bandabstand von wenigstens 2 eV aufweist. Geeignete Halbleitermaterialien sind beispielsweise Diamant, Galliumnitrit (GaN), Indiumphosphid (InP) oder vorzugsweise Siliciumcarbid (SiC). Auf Grund der durch den hohen Bandabstand bedingten extrem niedrigen intrinsischen Ladungsträgerkonzentration (= Ladungsträgerkonzentration ohne Dotierung) sind die genannten Halbleitermaterialien, insbesondere SiC, sehr vorteilhaft. Die genannten Halbleitermaterialien weisen im Vergleich zu dem "Universalhalbleiter" Silicium eine deutlich höhere Durchbruchsfestigkeit auf, so dass der Halbleiteraufbau auch bei einer höheren Sperrspannung einen sehr geringen Durchlassverlust aufweist. Das bevorzugte Halbleitermaterial ist Siliciumcarbid, insbesondere einkristallines Siliciumcarbid vom 3C- oder 4H- oder 6H- oder 15R-Polytyp.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen die:
- Figur 1: einen Halbleiteraufbau mit einem Schaltelement und einem Randelement,
- Figur 2: ein alternatives Schaltelement,
- Figur 3: einen Halbleiteraufbau mit mehreren Schaltelementen, einem Randelement und einem Steuerkontaktelement und
- Figur 4: ein alternatives Steuerkontaktelement.

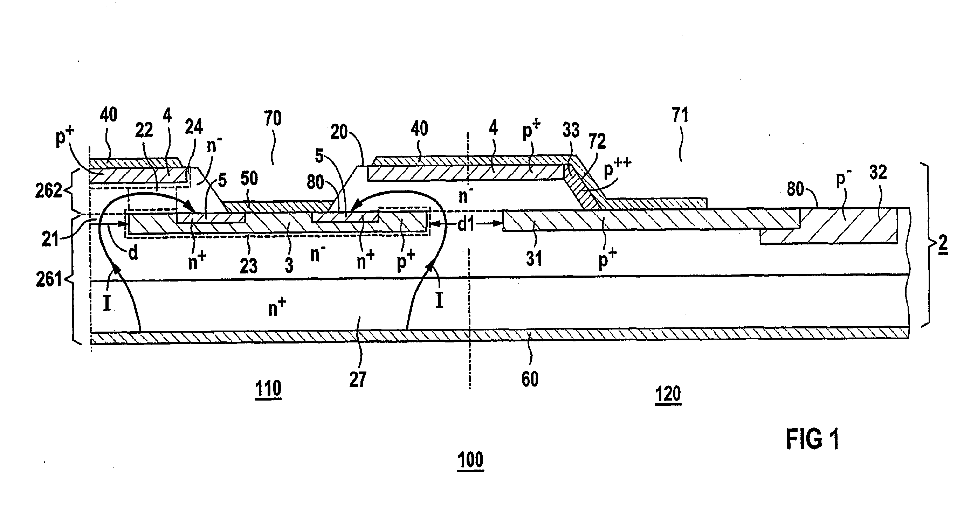

Einander entsprechende Teile sind in den Figuren 1 bis 4 mit denselben Bezugszeichen versehen.

In Figur 1 ist ein Halbleiteraufbau 100 mit einem Schaltelement 110 zur Steuerung eines Stroms I und mit einem Randelement 120 dargestellt. Zunächst werden Aufbau und Funktion des in Form eines vertikalen Sperrschicht-Feldeffekt-Transistors (JFET) vorliegenden Schaltelements 110 beschrieben. Das in Figur 1 gezeigte Schaltelement 110 stellt eine Einzelzelle dar, die durch mehrfache Spiegelung am linken Zellenrand zu einer Mehrzellenstruktur erweitert werden kann.

Der aktive Teil, in dem die Stromsteuerung im Wesentlichen stattfindet, ist in einem n-leitenden (Elektronenleitung) ersten Halbleitergebiet 2 enthalten. Innerhalb des ersten Halbleitergebiets 2 ist ein vorzugsweise implantiertes p-leitendes (Löcherleitung) vergrabenes Inselgebiet 3 angeordnet. Das erste Halbleitergebiet 2 weist eine erste Oberfläche 20, das vergrabene Inselgebiet 3 eine zweite Oberfläche 80 auf. Beide Oberflächen 20 und 80 laufen im Wesentlichen parallel zueinander. Das erste Halbleitergebiet 2 setzt sich im Ausführungsbeispiel von Figur 1 aus einem Halbleitersubstrat 27 und zwei darauf angeordneten, epitaktisch aufgewachsenen Halbleiterschichten 261 und 262 zusammen. Die erste Oberfläche 20 gehört zur zweiten Epitaxieschicht 262 und die zweite Oberfläche 80 zur ersten Epitaxieschicht 261. Die beiden Epitaxieschichten 261 und 262 weisen im Wesentlichen eine gleiche Grunddotierung auf. Sie sind niedriger dotiert (n⁻) als das Halbleitersubstrat 27 (n⁺).

An der zweiten Oberfläche 80 ist ein innerhalb des Inselgebiets 3 eingebettetes n-leitendes Kathoden-Kontaktgebiet 5 vorgesehen. Es ist hoch dotiert (n⁺) und ebenfalls insbesondere mittels Implantation hergestellt. Das Inselgebiet 3 erstreckt sich in allen Richtungen parallel zur ersten Oberfläche 20 weiter als das Kathoden-Kontaktgebiet 5.

Als Halbleitermaterial kommt in dem Halbleiteraufbau 100 Siliciumcarbid (SiC) zum Einsatz. Es eignet sich insbesondere bei hohen Spannungen auf Grund seiner spezifischen Materialeigenschaften besonders gut. Bevorzugte Dotierstoffe sind Bor und Aluminium für eine p-Dotierung sowie Stickstoff und Phosphor für eine n-Dotierung. Die Dotierstoffkonzentration des Kathoden-Kontaktgebiets 5 liegt typischerweise zwischen 1x10¹⁹ cm⁻³ und 1x10²⁰ cm⁻³ und die der beiden Epitaxieschichten 261 und 262 typischerweise bei höchstens 5x10¹⁶ cm⁻³. Das Zeichen 'x" wird hier als Multiplikationssymbol verwendet. Die Dotierung der ersten Epitaxieschicht 261 hängt insbesondere von der im Sperrfall von dem Halbleiteraufbau 100 aufzunehmenden Sperrspannung ab. Je höher die Sperrspannung ist, desto niedriger liegt diese Dotierung. Die Epitaxieschicht 261 hat im Wesentlichen das zu sperrende elektrische Feld zu tragen. Im gezeigten Beispiel haben beide Epitaxieschichten 261 und 262 eine Grunddotierung von etwa zwischen 5x10¹⁵ cm⁻³ und 7x10¹⁵ cm⁻³. Die Sperrspannung liegt dann mindestens bei 1200 v.

Innerhalb der zweiten Epitaxieschicht 262 ist ein beispielsweise mittels eines Trockenätzprozesses hergestelltes Kontaktloch 70 vorgesehen, das sich in vertikaler Richtung bis zu der zweiten Oberfläche 80 erstreckt. Das Kontaktloch 70 legt sowohl einen Teil des vergrabenen Inselgebiets 3 als auch einen Teil des Kathoden-Kontaktgebiets 5 frei, so dass beide Gebiete 3 und 5 mittels einer Kathodenelektrode 50 aus einem elektrisch leitenden Material ohmsch kontaktiert werden können. Das Kathoden-Kontaktgebiet 5 und das Inselgebiet 3 sind durch die Kathodenelektrode 50 kurz geschlossen. Als Material für die Kathodenelektrode 50 kommt Polysilicium oder ein Metall, vorzugsweise Nickel, Aluminium, Tantal, Titan oder Wolfram, in Frage.

Auf einer von der ersten Oberfläche 20 abgewandten Seite des ersten Halbleitergebiets 2 ist eine Anodenelektrode 60 vorgesehen. Die Zu- und Ableitung des durch den Halbleiteraufbau 100 fließenden Stroms I erfolgt mittels der beiden Elektroden 50 und 60. Auf Grund des im Wesentlichen vertikalen, d.h. senkrecht zur ersten Oberfläche 20 verlaufenden Strompfades wird der Halbleiteraufbau 100 auch als vertikal bezeichnet.

Seitlich (= lateral) neben dem Kontaktloch 70 ist ein zweites Halbleitergebiet 4 an der ersten Oberfläche 20 innerhalb des ersten Halbleitergebiets 2 angeordnet. Es ist p-leitend, insbesondere stark p-leitend (p⁺) und vorzugsweise mittels Ionenimplantation erzeugt. Zwischen dem ersten Halbleitergebiet 2 und dem zweiten Halbleitergebiet 4 ist ein p-n-Übergang mit einer ersten Verarmungszone 24, die sich im Wesentlichen in das erste Halbleitergebiet 2 erstreckt. Ein weiterer p-n-Übergang mit einer zweiten Verarmungszone 23 ist zwischen dem ersten Halbleitergebiet 2 und dem vergrabenen Inselgebiet 3 vorhanden. Die zweite Verarmungszone 23 umgibt das gesamte vergrabene Inselgebiet 3. Soweit sich die beiden Verarmungszonen 23 und 24 in das erste Halbleitergebiet 2 erstrecken, sind sie in Figur 1 gestrichelt eingezeichnet. Die erste und die zweite Verarmungszone 24 bzw. 23 begrenzen in vertikaler Richtung ein laterales Kanalgebiet 22, das innerhalb des ersten Halbleitergebiets 2 liegt und Teil des Strompfads zwischen den beiden Elektroden 50 bzw. 60 ist. Die erste Verarmungszone 24 und das vergrabene Inselgebiet 3 sind so angeordnet, dass sich die beiden Verarmungszonen 23 und 24 in einer Projektion auf die erste Oberfläche 20 an ihren seitlichen Rändern überlappen. Das laterale Kanalgebiet 22 befindet sich gerade innerhalb dieses Überlappungsbereichs.

Der Hauptstrompfad zwischen der Kathoden- und Anodenelektrode 50 bzw. 60 umfasst neben dem lateralen Kanalgebiet 22 und dem Kathoden-Kontaktgebiet 5 auch ein weiteres ebenfalls im ersten Halbleitergebiet 2 angeordnetes vertikales Kanalgebiet 21 sowie eine sich danach anschließende Driftzone, die aus dem verbleibenden Teil der ersten Epitaxieschicht 261 und dem Substrat 27 besteht.

Typischerweise beträgt die Länge (= laterale Ausdehnung) des lateralen Kanalgebiets 22 bei einem aus Siliciumcarbid hergestellten Halbleiteraufbau 100 zwischen 1 µm und 5 µm. Vorzugsweise ist das laterale Kanalgebiet 22 möglichst kurz ausgebildet. Dann ergibt sich ein sehr kompakter Gesamtaufbau mit geringem Platzbedarf. Die vertikale Ausdehnung liegt im spannungs- und stromfreien Zustand typischerweise zwischen 0,5 µm und 2 µm. Die Verarmungszonen 23 und 24 sind durch eine starke Verarmung an Ladungsträgern gekennzeichnet und weisen damit einen wesentlich höheren elektrischen Widerstand auf, als das von ihnen in vertikaler Richtung begrenzte laterale Kanalgebiet 22. Die räumliche Ausdehnung der beiden Verarmungszonen 23 und 24, insbesondere die in vertikaler Richtung, variiert in Abhängigkeit der herrschenden Strom- und Spannungsverhältnisse.

Das laterale Kanalgebiet 22 bestimmt maßgeblich das (Steuerungs-)Verhalten des gesamten Halbleiteraufbaus 100. Bei einer Ausbildung als Strombegrenzer hängt das Verhalten bei Anliegen einer Betriebsspannung in Durchlassrichtung (= Vorwärtsrichtung) von dem zwischen den beiden Elektroden 50 und 60 durch den Halbleiteraufbau 100 fließenden elektrischen Strom I ab. Mit steigender Stromstärke wächst auf Grund des Bahnwiderstands der Vorwärtsspannungsabfall zwischen den Elektroden 50 und 60. Dies führt zu einer Vergrößerung der Verarmungszonen 23 und 24 und folglich zu einer mit einer entsprechenden Widerstandserhöhung verbundenen Verminderung der stromtragenden Querschnittsfläche im lateralen Kanalgebiet 22. Bei Erreichen eines bestimmten kritischen Stromwerts (= Sättigungsstrom) berühren sich die beiden Verarmungszonen 23 und 24 und schnüren das laterale Kanalgebiet 22 vollständig ab.

Eine derartige Kanalabschnürung kann auch durch Anlegen einer Steuerspannung an eine Steuerelektrode 40, mit der das zweite Halbleitergebiet 4 ohmsch kontaktiert ist, erreicht werden. Über die externe Steuerspannung kann die Ausdehnung der Verarmungszone 24 in vertikaler Richtung und damit der Stromfluss im Kanalgebiet 22 beeinflusst werden.

Die erste Verarmungszone 24, die im Wesentlichen die extern kontrollierbare Beeinflussung des Kanalgebiets 22 bewirkt, kann grundsätzlich auf verschiedene Weise innerhalb des ersten Halbleitergebiets 2 hervorgerufen werden. Aus der WO 00/16403 A1 bekannte Ausführungsformen umfassen beispielsweise einen auf der ersten Oberfläche 20 angeordneten Schottky-Kontakt oder MOS (Metal Oxide Semiconductor)-Kontakt.

Das Schaltelement 110 selbst weist gerade bei einer Realisierung in SiC eine sehr hohe intrinsische Sperrspannungsfestigkeit auf. Bedingt durch die endliche Ausdehnung kann es jedoch an der Peripherie des Schaltelements 110 zu einer Überhöhung des elektrischen Felds insbesondere an der ersten Oberfläche 20 kommen. Ohne Zusatzmaßnahme zur Reduzierung dieses kritischen Oberflächenfelds wird der Durchbruch des Schaltelements 110 und damit seine Sperrspannungsfestigkeit nicht durch das günstige Volumenverhalten, sondern durch die Randgegebenheiten bestimmt. Die Sperrspannungsfestigkeit des gesamten Halbleiteraufbaus 100 sinkt dadurch.

Um dies zu vermeiden, ist benachbart zum Schaltelement 110 das Randelement 120 angeordnet. Es enthält in Form eines schwach p-dotierten (p⁻) Randabschlussgebiets 32 einen einstufigen JTE-Randabschluss. Grundsätzlich ist auch eine in der EP 0 772 889 B1 beschriebene mehrstufige Ausführungsform möglich.

Der Halbleiteraufbau 100 ist insbesondere auch zu einem Einsatz als Hochvolt-Bauelement in einer Kaskodenschaltung bestimmt. Bei dieser speziellen Schaltungsvariante ist die Steuerelektrode 40 an einen der beiden Hauptanschlüsse der Kaskodenschaltung angeschlossen und liegt damit im Sperrfall auch am vollen Sperrpotential. Es hat sich gezeigt, dass es günstig ist, den Randabschluss an die Steuerelektrode 40 anzuschließen.

Dabei kann allerdings eine in Figur 1 nicht vorgesehene Anordnung des Randabschlussgebiets 32 auf Höhe des zweiten Halbleitergebiets 4 im Sperrfall trotzdem noch zu einer unerwünschten lokalen Felderhöhung führen. Der Ort dieser lokalen Feldspitze liegt an der dem Randelement 120 zugewandten seitlichen Kante des vergrabenen Inselgebiets 3, insbesondere an der unteren rechten Ecke. Der Potentiallinienverlauf wird an dieser Stelle zusätzlich gekrümmt, und damit die Sperrspannungsfestigkeit vermindert. Es wurde erkannt, dass die Ursache für die lokale Felderhöhung in dem an der ersten Oberfläche 20 positionierten Randabschlussgebiet 32 zu sehen ist und dass eine Verbesserung durch ein Tiefersetzen erreicht werden kann.

Dementsprechend ist das Randabschlussgebiet 32 im Beispiel von Figur 1 nicht auf Höhe der zweiten Halbleitergebiets 4, sondern auf Höhe des vergrabenen Inselgebiets 3 an der zweiten Oberfläche 80 angeordnet. Der Anschluss an die Steuerelektrode 40 erfolgt über ein stark p-leitendes (p⁺) vergrabenes Randgebiet 31, das entsprechend dem Inselgebiet 3 des Schaltelements 110 ausgebildet ist. Zumindest ein Teil der Oberflächen des Randgebiets 31 und des Randabschlussgebiet 32 sind beispielsweise mittels eines Ätzprozesses freigelegt. Die Metallisierung der Steuerelektrode 40 erstreckt sich in die so gebildete Ausnehmung 71 bis zum Randgebiet 31. Bei einer nicht gezeigten Alternative kann der elektrisch leitende Anschluss des Randgebiets 31 an das zweite Halbleitergebiet 4 auch nur über ein p-leitendes Verbindungsgebiet 33 erfolgen. Die Steuerelektrode 40 erstreckt sich dann nicht bis zum Randgebiet 31.

Die Anordnung von Insel-, Rand- und Randabschlussgebiet 3, 31 bzw. 32 auf gleicher Höhe führt zu einer reduzierten Potentiallinienkrümmung und zu einer reduzierten kritischen Feldstärke im Randelement 120, so dass der Halbleiteraufbau 100 insgesamt bei ansonsten gleicher Dotierung und Dicke eine um etwa 30% erhöhte Sperrspannungsfestigkeit aufweist.

Günstig hinsichtlich einer möglichst geringfügigen Krümmung der Potentiallinien im Randelement 120 wirkt es sich weiterhin aus, wenn ein Abstand d1 zwischen dem Inselgebiet 3 und dem Randgebiet 31 höchstens gleich einem Abstand d zwischen den Inselgebieten 3 benachbarter Schaltelemente 110 ist (d1 ≤ d). Wenn der Halbleiteraufbau 100 also in einer Mehrzellenstruktur mit einer Vielzahl von Schaltelementen 110 und mit einem einheitlichen Rastermaß vorliegt, beträgt der Abstand d zwischen den Inselgebieten 3 benachbarter Schaltelemente 110 beispielsweise einheitlich jeweils 5 µm. Ein typischer Wert des Abstands d1 zum Randelement 120 liegt dann bei 3,5 µm. In diesem Fall, d.h. wenn d1 kleiner als d ist, hat das Randelement 120 eine höhere Sperrspannungsfestigkeit als das Schaltelement 110. Ein etwaiger Avalanche-Durchbruch tritt im Sperrfall dann nicht im Randelement 120 auf, sondern bevorzugt homogen verteilt im Volumen der insbesondere in großer Anzahl vorhandenen Schaltelemente 110. Der Avalanche-Strom fließt damit nicht oder nur zu einem unerheblichen Teil in dem nur für einen geringen Stromfluss ausgelegten Steuerkreis. Stattdessen fließt er größtenteils über die beiden ohnehin für einen hohen Stromwert ausgelegten Elektroden 50 und 60 (= Lastkreis).

Am seitlichen Rand 72 der Ausnehmung 71 ist zur Vermeidung eines Leckstroms zwischen der Kathodenelektrode 50 und der Steuerelektrode 40 ein insbesondere sehr stark p-leitendes (p++) Verbindungsgebiet 33 vorgesehen. Es stellt eine p-leitende Verbindung zwischen dem zweiten Halbleitergebiet 4 und dem Randgebiet 31 her. Es gibt auch andere Möglichkeiten zur Vermeidung des Leckstroms, beispielsweise eine zusätzlich zwischen dem seitlichen Rand 72 und der Steuerelektrode 40 angeordnete isolierende Oxidschicht oder eine spezielle Wahl des für die Steuerelektrode 40 verwendeten Kontaktmetalls, so dass auf einem p-leitenden Gebiet ein ohmscher Kontakt, auf einem n-leitenden Gebiet dagegen ein Schottky-Kontakt gebildet ist.

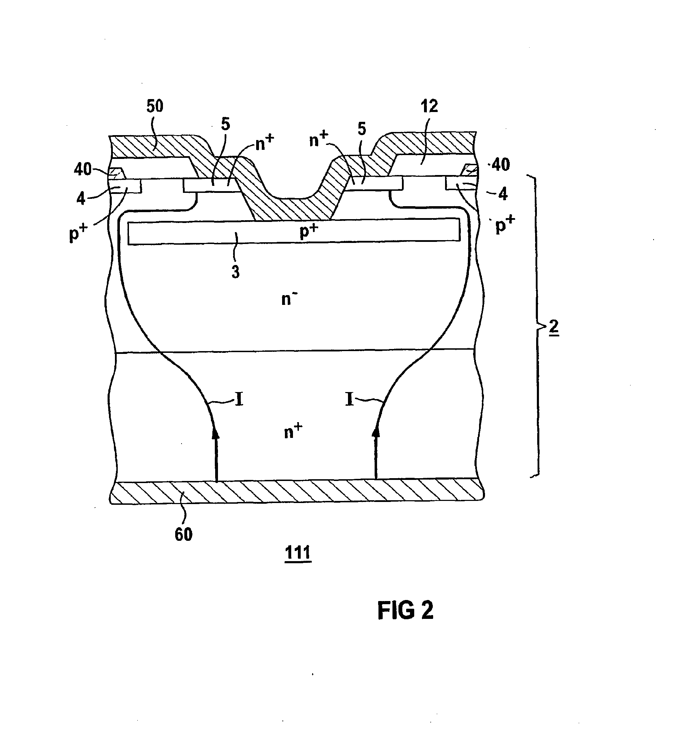

Eine mögliche Alternative zu dem in Figur 1 gezeigten Schaltelement 110 ist in Figur 2 in Form eines Schaltelements 111 dargestellt. Der wesentliche Unterschied besteht darin, dass das Kathoden-Kontaktgebiet 5 nicht innerhalb des vergrabenen Inselgebiets 3, sondern an der ersten Oberfläche 20 angeordnet ist. An der im Zusammenhang mit Figur 1 beschriebenen grundsätzlichen Funktionsweise ändert dies jedoch nichts.

Außerdem ist eine mögliche Anordnung der Kathodenelektrode 50 und der Steuerelektrode 40, die beide auf der gleichen Seite des Schaltelements 111 platziert sind, gezeigt. Die für einen großen Stromfluss und damit großflächiger ausgelegte Kathodenelektrode 50 ist mittels einer insbesondere aus Oxid bestehenden Isolationsschicht 12 von der für einen kleinen Stromfluss und damit kleinflächiger ausgelegten Kathodenelektrode 50 getrennt.

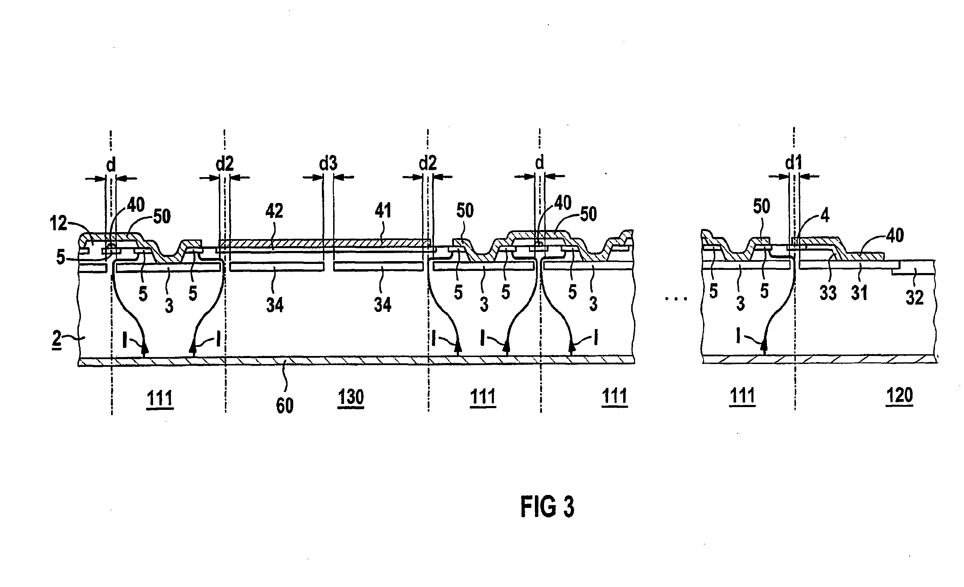

In Figur 3 ist ein Halbleiteraufbau 200 in Mehrzellenstruktur mit einer Vielzahl parallel geschalteter Schaltelemente 111 sowie mit einem Randelement 120 und mit einem Steuerkontaktelement 130 gezeigt. Das zusätzlich vorgesehene Steuerkontaktelement 130 dient dem Anschluss einer externen Steuerzuleitung an die untereinander verbundenen Steuerelektroden 40 der einzelnen Schaltelemente 111. Insbesondere ist es in diesem Bereich möglich, eine solche Steuerzuleitung anzubonden.

Das zwischen zwei Schaltelementen 111, beispielsweise im Zentrum des Halbleiteraufbaus 200 angeordnete Steuerkontaktelement 130 enthält ein stark p-leitendes (p⁺) Steuer-Kontaktgebiet 42, das mittels eines Steuerelektroden-Anschlusses 41 ohmsch kontaktiert ist. Das Steuer-Kontaktgebiet 42 und der Steuerelektroden-Anschluss 41 sind mit den jeweiligen zweiten Halbleitergebieten 4 bzw. den jeweiligen Steuerelektroden 40 der einzelnen Schaltelemente 111 leitend verbunden.

Um auch im Bereich des Steuerkontaktelements 130 Felderhöhungen zu vermeiden, sind im Steuerkontaktelement 130 mehrere stark p-leitende (p⁺) vergrabene Inselgebiete 34 auf gleicher Höhe wie die vergrabenen Inselgebiete 3 der Schaltelemente 111 vorgesehen. Die Inselgebiete 34 des Steuerkontaktelements 130 sind nicht leitend mit den Inselgebieten 3 der Schaltelemente 111 verbunden. Sie sind vielmehr floatend ausgeführt. Dennoch bewirken auch sie die günstige Homogenisierung des Feldlinienverlaufs, d.h. sie reduzieren die ansonsten vorhandenen Krümmungen der Potentiallinien. Günstig wirkt es sich auch hier aus, wenn die Abstände d2 zwischen den Inselgebieten 34 untereinander und die Abstände d3 zu den Inselgebieten 3 der benachbarten Schaltelemente 111 möglichst einheitlich und jeweils höchstens gleich groß wie der einheitliche Abstand d der Inselgebiete 3 untereinander sind. Beispielsweise können d2 und d3 auch gleich d sein. Dies bedeutet, dass das Rastermaß der Mehrzellenstruktur auch im Bereich des Steuerkontaktelements 130 eingehalten wird.

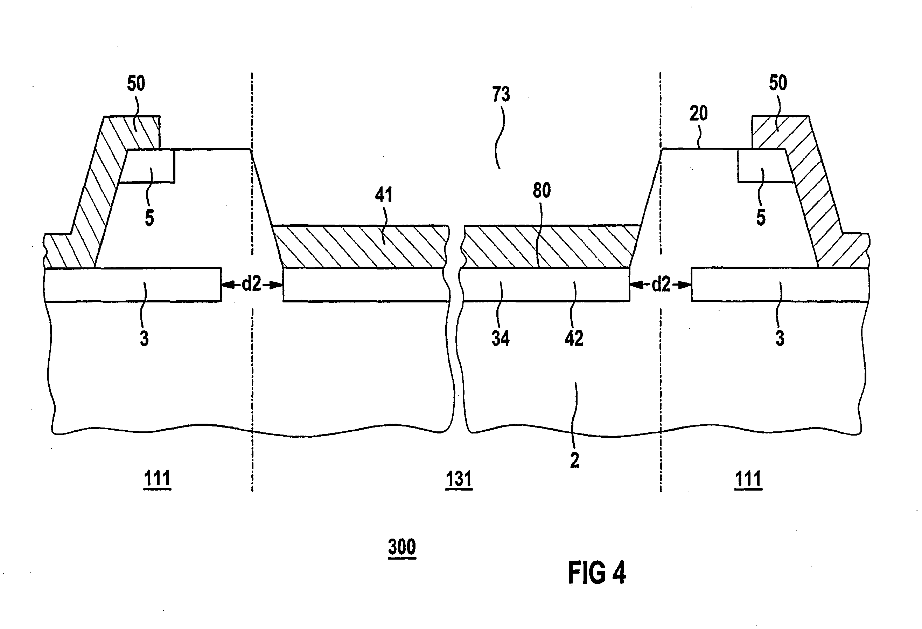

In Figur 4 ist ein Halbleiteraufbau 300 mit einer alternativen Ausgestaltung eines Steuerkontaktelements 131 gezeigt, bei der die vergrabenen Inselgebiete 34 und das Steuer-Kontaktgebiet 42 zu einem einzigen Gebiet zusammenfallen. Das Steuer-Kontaktgebiet 42 liegt dann auf Höhe der Inselgebiete 3 der Schaltelemente 111 und ist wiederum vorzugsweise in dem einheitlichen Abstand d zu den Inselgebieten 3 der benachbarten Schaltelemente 111 angeordnet. Die Kontaktierung mittels des Steuerelektroden-Anschlusses 41 erfolgt in einer bis zur zweiten Oberfläche 80 reichenden Ausnehmung 73. Es ist also eine abgesenkte Steuerelektroden-Kontaktierung mit gleichzeitiger feldhomogenisierender Wirkung vorgesehen.

Es versteht sich, dass die bei den Halbleiteraufbauten 100, 200, und 300 in den jeweiligen Halbleitergebieten vorgesehenen Leitungstypen bei alternativen Ausführungsformen auch den jeweils entgegengesetzten Leitungstyp annehmen können.

## Patentansprüche

1. Halbleiteraufbau zum Steuern und Schalten eines Stroms (I) umfassend mindestens:
a) ein Schaltelement (110,111) mit
a1) einem mittels einer Anodenelektrode (60) und einer Kathodenelektrode (50) kontaktierten ersten Halbleitergebiet (2) eines ersten Leitungstyps, innerhalb dessen ein Pfad für den Strom (I) verläuft,
a2) einer zumindest teilweise innerhalb des ersten Halbleitergebiets (2) angeordneten ersten Verarmungszone (24), die zur Stromsteuerung mittels einer an einer Steuerelektrode (40) anstehenden Steuerspannung beeinflussbar ist, und
a3) einem zumindest teilweise innerhalb des ersten Halbleitergebiets (2) vergrabenen Inselgebiet (3) eines zweiten gegenüber dem ersten Leitungstyp entgegengesetzten Leitungstyps, das durch die Kathodenelektrode (50) an einer Oberfläche (80) kontaktiert ist, die der Anodenelektrode (60) gegenüberliegt,
b) ein Randelement (120) mit
b1) einem zumindest teilweise innerhalb des ersten Halbleitergebiets (2) vergrabenen Randgebiet (31) des zweiten Leitungstyps, das auf gleicher Höhe wie das vergrabene Inselgebiet (3) angeordnet ist, und
b2) einem an das Randgebiet (31) angrenzenden Randabschlussgebiet (32) des zweiten Leitungstyps,
b3) wobei zwischen der Steuerelektrode (40) und dem Randgebiet (31) eine elektrisch leitende Verbindung besteht.

2. Halbleiteraufbau nach Anspruch 1 mit einem innerhalb des ersten Halbleitergebiets (2) angeordneten Kanalgebiet (22), durch das der Pfad für den Strom (I) verläuft, und innerhalb dessen der Strom (I) mittels der ersten Verarmungszone (24) beeinflussbar ist.

3. Halbleiteraufbau nach einem der vorhergehenden Ansprüche, bei dem die erste Verarmungszone (24) die eines p-n-Übergangs ist, der zwischen dem ersten Halbleitergebiet (2) und einem zweiten Halbleitergebiet (4) des zweiten Leitungstyps, das an einer Oberfläche (80) innerhalb des ersten Halbleitergebiets (2) angeordnet ist, gebildet ist.

4. Halbleiteraufbau nach einem der vorhergehenden Ansprüche, bei dem die erste Verarmungszone (24) oberhalb des vergrabenen Inselgebiets (3) angeordnet ist.

5. Halbleiteraufbau nach einem der vorhergehenden Ansprüche mit einer Vielzahl benachbart zueinander angeordneter Schaltelemente (110, 111).

6. Halbleiteraufbau nach Anspruch 5, bei dem die Abstände (d) zwischen den vergrabenen Inselgebieten (3) benachbarter Schaltelemente (110, 111) gleich groß sind.

7. Halbleiteraufbau nach einem der Ansprüche 5 und 6, bei dem ein Abstand (d1) zwischen dem vergrabenen Inselgebiet (3) des an das Randelement (120) angrenzenden Schaltelements (110, 111) und dem vergrabenen Randgebiet (31) höchstens gleich groß ist wie die Abstände (d) zwischen den vergrabenen Inselgebieten (3) benachbarter Schaltelemente (110, 111).

8. Halbleiteraufbau nach einem der Ansprüche 5 bis 7, bei dem ein zwischen zwei Schaltelementen (110, 111) angeordnetes Steuerkontaktelement (130, 131) vorgesehen ist, das leitend mit den Steuerelektroden (40) der zwei Schaltelemente verbunden ist.

9. Hälbleiteraufbau nach Anspruch 8, bei dem das Steuerkontaktelement (130, 131) mindestens ein vergrabenes Inselgebiet (34) des zweiten Leitungstyps enthält, das insbesondere auf gleicher Höhe angeordnet ist wie das vergrabene Inselgebiet (3) des Schaltelements (110, 111).

10. Halbleiteraufbau nach einem der Ansprüche 8 und 9, bei dem ein Abstand (d2) zwischen dem vergrabenen Inselgebiet (3) des an das Steuerkontaktelement (130) angrenzenden Schaltelements (111) und einem vergrabenen Inselgebiet (34) des Steuerkontaktelements (130) höchstens gleich groß ist wie die Abstände (d) zwischen den vergrabenen Inselgebieten (3) benachbarter Schaltelemente (111).

11. Halbleiteraufbau nach einem der Ansprüche 8 bis 10, bei dem das Steuerkontaktelement (130) ein Steuer-Kontaktgebiet (42) des zweiten Leitungstyps enthält.

12. Halbleiteraufbau nach Anspruch 9 und 11, bei dem das Steuer-Kontaktgebiet (42) und das vergrabene Inselgebiet (34) des Steuerkontaktelements (131) zusammenfallen.

13. Halbleiteraufbau nach einem der vorhergehenden Ansprüche, bei dem zur Kontaktierung des vergrabenen Randgebiets (31) mittels der Steuerelektrode (40) eine Ausnehmung (71) vorgesehen ist.

14. Halbleiteraufbau nach Anspruch 13, bei dem am seitlichen Rand (72) der Ausnehmung (71) eine Isolierung (33) vorgesehen ist.

15. Halbleiteraufbau nach einem der Ansprüche 13 und 14, bei dem am seitlichen Rand (72) der Ausnehmung (71) innerhalb des ersten Halbleitergebiets (2) ein Verbindungsgebiet (33) des zweiten Leitungstyps vorgesehen ist.

16. Halbleiteraufbau nach einem der vorhergehenden Ansprüche, bei dem Siliciumcarbid als Halbleitermaterial vorgesehen ist.

## Claims

1. Semiconductor structure for controlling and switching a current (I) comprising at least:
a) a switch element (110, 111) with
a1) a first semiconductor area (2) of a first type of conduction which is contacted by means of an anode electrode (60) and a cathode electrode (50) and within which a path extends for the current (I),
a2) a first depletion zone (24) arranged at least partially within the first semiconductor area (2), which can be influenced by means of a control voltage present at a control electrode (40) for the purpose of controlling the current, and
a3) an island area (3) buried at least partially within the first semiconductor area (2) of a second type of conduction which is opposite to the first type of conduction, which island area (3) is contacted on a surface (80) by the cathode electrode (50) which is opposite the anode electrode (60),
b) an edge element (120) comprising
b1) an edge area (31), buried at least partially within the first semiconductor area (2), of the second type of conduction which is arranged at the same level as the buried island area (3), and
b2) an edge termination area (32) of the second type of conduction, adjoining the edge area (31),
b3) an electrically conductive connection existing between the control electrode (40) and the edge area (31).

2. Semiconductor structure according to Claim 1, with a channel area (22), arranged within the first semiconductor area (2), through which the path extends for the current (I) and within which the current (I) can be influenced by means of the first depletion zone (24).

3. Semiconductor structure according to either of the preceding claims, in which the first depletion zone (24) is that of a p-n junction which is formed between the first semiconductor area (2) and a second semiconductor area (4) of the second type of conduction which is arranged on a surface (80) within the first semiconductor area (2).

4. Semiconductor structure according to one of the preceding claims, in which the first depletion zone (24) is arranged above the buried island area (3).

5. Semiconductor structure according to one of the preceding claims, comprising a multiplicity of switch elements (110, 111) arranged adjacently to one another.

6. Semiconductor structure according to Claim 5, in which the distances (d) between the buried island areas (3) of adjacent switch elements (110, 111) are of equal magnitude.

7. Semiconductor structure according to one of Claims 5 and 6, in which a distance (d1) between the buried island area (3) of the switch element (110, 111) adjoining the edge element (120) and the buried edge area (31) is at a maximum equal to the magnitude of the distances' (d) between the buried island areas (3) of adjacent switch elements (110, 111).

8. Semiconductor structure according to one of Claims 5 to 7, in which a control contact element (130, 131) is provided which, is arranged between two switch elements (110, 111), which control contact element (130, 131) is conductively connected to the control electrodes (40) of the two switch elements.

9. Semiconductor structure according to Claim 8, in which the control contact element (130, 131) contains at least one buried island area (34) of the second type of conduction which, in particular, is arranged at the same level as the buried island area (3) of the switch element (110, 111).

10. Semiconductor structure according to one of Claims 8 and 9, in which a distance (d2) between the buried island area (3) of the switch element (111) adjoining the control contact element (130) and a buried island area (34) of the control contact element (130) is at a maximum of the same magnitude as the distances (d) between the buried island areas (3) of adjacent switch elements (111).

11. Semiconductor structure according to one of Claims 8 to 10, in which the control contact element (130) contains a control contact area (42) of the second type of conduction.

12. Semiconductor structure according to Claim 9 and 11, in which the control contact area (42) and the buried island area (34) of the control contact element (131) coincide.

13. Semiconductor structure according to one of the preceding claims, in which a recess (71) is provided for contacting the buried edge area (31) by means of the control electrode (40).

14. Semiconductor structure according to Claim 13, in which an insulation (33) is provided at the lateral edge (72) of the recess (71).

15. Semiconductor structure according to one of Claims 13 and 14, in which a connecting area (33) of the second type of conduction is provided at the lateral edge (72) of the recess (71) within the first semiconductor area (2).

16. Semiconductor structure according to one of the preceding claims, in which silicon carbide is provided as semiconductor material.

## Revendications

1. Structure semiconductrice pour la commande et la commutation d'un courant (I), comprenant au moins :
a) un élément (110, 111) de commutation ayant
a1) une première région (2) semiconductrice, d'un premier type de conductivité, mise en contact au moyen d'une électrode (60) d'anode et d'une électrode (50) de cathode, au sein de laquelle s'étend un trajet pour le courant (I),
a2) une première zone (24) d'appauvrissement, qui est disposée, au moins en partie, au sein de la première région (2) semiconductrice et qui peut, pour la commande du courant, être influencée au moyen d'une tension de commande appliquée à une électrode (40) de commande, et
a3) une région (30) formant îlot, d'un deuxième type de conductivité opposé au premier type de conductivité, qui est enterrée, au moins en partie, au sein de la première région (2) semiconductrice et qui est mise en contact par l'électrode (50) de cathode sur une surface (80), qui est opposée à l'électrode (60) d'anode,
b) un élément (120) de bord comprenant
b1) une région (31) de bord, du deuxième type de conductivité, qui est enterrée, au moins en partie, au sein de la première région (2) semiconductrice et qui est au même niveau que la région (3) enterrée formant îlot, et
b2) une région (32) du deuxième type de conductivité de fermeture de bord voisine de la région (31) de bord,
b3) une liaison conductrice de l'électricité existant entre l'électrode (40) de commande et la région (31) de bord.

2. Structure semiconductrice suivant la revendication 1, ayant une région (22) de canal, qui est disposée au sein de la première région (2) semiconductrice, dans laquelle passe le trajet pour le courant (I) et au sein de laquelle le courant (I) peut être influencé au moyen de la première zone (24) d'appauvrissement.

3. Structure semiconductrice suivant l'une des revendications précédentes, dans laquelle la première zone (24) d'appauvrissement est une jonction p-n, qui est formée entre la première région (2) semiconductrice et une deuxième région (4) semiconductrice du deuxième type de conductivité, qui est disposée sur une surface (80) au sein de la première région (2) semiconductrice.

4. Structure semiconductrice suivant l'une des revendications précédentes, dans laquelle la première zone (24) d'appauvrissement est disposée au-dessus de la région (3) enterrée formant îlot.

5. Structure semiconductrice suivant l'une des revendications précédentes, comprenant une pluralité d'éléments (110, 111) de commutation disposés au voisinage les uns des autres.

6. Structure semiconductrice suivant la revendication 5, dans laquelle les distances (d) entre les zones (3) enterrées formant îlot d'éléments (110, 111) de commutation voisins sont de mêmes dimensions.

7. Structure semiconductrice suivant l'une des revendications 5 et 6, dans laquelle une distance (d1) entre la région (3) enterrée formant îlot de l'élément (110, 111) de commutation voisin de l'élément (120) de bord et la région (31) de bord enterrée est au plus égale aux distances (d) entre les régions (3) enterrées formant îlot d'éléments (110, 111) de commutation voisins.

8. Structure semiconductrice suivant l'une des revendications 5 à 7, dans laquelle il est prévu, entre deux éléments (110, 111) de commutation, un élément (130, 131) de contact de commande, qui est relié d'une manière conductrice aux électrodes (40) de commande des deux éléments de commutation.

9. Structure semiconductrice suivant la revendication 8, dans laquelle l'élément (130, 131) de contact de commande comporte au moins une région (34) enterrée formant îlot du deuxième type de conductivité, qui est disposée notamment au même niveau que la région (3) enterrée formant îlot de l'élément (110, 111) de commutation.

10. Structure semiconductrice suivant l'une des revendications 8 et 9, dans laquelle une distance (d2) entre la région (3) enterrée formant îlot de l'élément (11) de commutation voisin de l'élément (130) de contact de commande et une région (34) enterrée formant îlot de l'élément (130) de contact de commande est au plus aussi grande que les distances (d) entre les régions (3) enterrées formant îlot d'éléments (111) de commutation voisins.

11. Structure semiconductrice suivant l'une des revendications 8 à 10, dans laquelle l'élément (130) de contact de commande comporte une zone (42) de contact de commande du deuxième type de conductivité.

12. Structure semiconductrice suivant la revendication 9 et 11, dans laquelle la zone (42) de contact de commande et la zone (34) enterrée formant îlot de l'élément (131) de contact de commande coïncident.

13. Structure semiconductrice suivant l'une des revendications précédentes, dans laquelle il est prévu un évidement (71) pour la mise en contact de la zone (31) enterrée de bord au moyen de l'électrode (40) de commande.

14. Structure semiconductrice suivant la revendication 13, dans laquelle il est prévu un isolant (33) au bord (72) latéral de l'évidement (71).

15. Structure semiconductrice suivant l'une des revendications 13 et 14, dans laquelle il est prévu une région (33) de liaison du deuxième type de conductivité au bord (72) latéral de l'évidement (71) au sein de la première région (2) semiconductrice.

16. Structure semiconductrice suivant l'une des revendications précédentes, dans laquelle il est prévu du carbure de silicium comme matériau semiconducteur.
